# EUROPEAN PATENT APPLICATION

(11) **EP 2 429 271 A2**
(43) Date of publication of application: **14.03.2012**
(21) Application number: 11275110.2
(22) Date of filing: 09.09.2011
(51) Int. Cl.: H05K 5/00

(54) **Rail seal for electronic equipment enclosure**

(30) Priority: 10.09.2010 US 381909 P
(71) Applicant: Chatsworth Products, Inc., Austin, TX 78731 (US)
(72) Inventor: Garza Jr., Jose Arturo, Pflugerville, TX Texas 78660 (US); Alaniz, Daniel, Austin, TX Texas 78730 (US); Donowho, David Brian, Austin, TX Texas 78717 (US)
(74) Representative: Robinson, Simon John

(57) **Abstract**

An electronic equipment enclosure (10) includes a frame structure (12), one or more panels (14, 17) attached to the frame structure, at least one vertical mounting rail (30) fastened to the frame structure, and a rail seal (40) attached to the at least one vertical mounting rail. The rail seal includes a generally flat panel portion and a seal along an edge thereof. The seal is adapted to engage at least one of the one or more panels to provide an air dam between the one or more panels and the at least one vertical mounting rail.

## Description

### Technical Field

The present invention relates generally to electronic equipment cabinet structures and enclosures, and, in particular, to rail seals for installing on vertical mounting rails in electronic equipment cabinet structures and enclosures.

### Background

Racks, frames and cabinets for mounting and storing electronic components have been well known for many years. Frames and racks are typically simple rectangular frameworks on which electronic components may be mounted, or on which other mounting members, such as shelves or brackets, may be mounted which in turn may support the electronic components. Cabinets are typically frames on which panels or doors, or both, are hung to provide aesthetic improvement, to protect the components from external influences, to provide security for the components stored inside, or for other reasons. Racks, frames and cabinets (sometimes collectively referred to hereinafter as "enclosures") are often customized in order to best accommodate the components which they are designed to store.

Air dam kits are commonly installed in an enclosure in order to establish a barrier between interior portions of the enclosure. In so doing, air dam kits are used to direct air flow within the enclosure to cool equipment installed therein. Many known air dam kits involve bulky, three-dimensional structures that are often difficult to install within an enclosure during initial set-up and are particularly difficult to retrofit into an existing enclosure. In a retrofitting process, side paneling may need to be removed from the enclosure in order to provide the necessary access point for properly installing the air dam kit. Additionally, known air dam kits can occupy substantial internal space within the enclosure, thereby obstructing the implementation of various cable routing accessories and equipment and compromising the flexibility of the enclosure for a wider range of uses.

Accordingly, a need exists for a more efficient type of air dam kit that occupies less space within an enclosure and can be installed with relative ease. Further, a need exists for a type of air dam kit that can be retrofitted into an existing enclosure through a front access point. Still further, a need exists for a type of air dam kit that is readily adaptable across a wide range of enclosure features and accessories and can accommodate front-to-back cable routing.

### SUMMARY

While many aspects and features relate to, and are described in, the context of enclosures for electronic equipment, the present invention is not limited to use only in enclosures for electronic equipment, as will become apparent from the following summaries and detailed descriptions of aspects, features, and one or more embodiments of the present invention.

Broadly defined, the present invention according to a first aspect includes an electronic equipment enclosure that includes a frame structure, one or more panels attached to the frame structure, a vertical mounting rail fastened to the frame structure; and a rail seal attached to the vertical mounting rail. The rail seal includes a generally flat panel portion and a seal along an edge thereof. The seal is adapted to engage at least one of the one or more panels to provide a vertical air dam between the one or more panels and the vertical mounting rail.

In features of this aspect, the rail seal may further include one or more grommet ports in the panel portion for routing of cables therethrough; the rail seal may be attachable to the vertical mounting rail with one or more self-tapping screws; the panel portion may include a notched area for accommodating a finger cable manager; the seal may include an internal cavity extending substantially the length thereof; the seal may include a hooked portion for clamping the edge of the panel portion; and the seal may be shaped as a wiper blade.

Broadly defined, the present invention according to a second aspect includes an electronic equipment enclosure as substantially shown and described.

Broadly defined, the present invention according to a third aspect includes a rail seal for attachment to a vertical mounting rail in an electronic equipment enclosure. The rail seal includes a generally flat panel portion, a seal along an edge thereof, and one or more grommet ports in the panel portion for routing of cables therethrough. The seal is adapted to engage a panel of an electronic equipment enclosure to provide a vertical air dam therein.

In feature of this aspect, the rail seal may be attachable with one or more self-tapping screws; the panel portion may include a notched area for accommodating a finger cable manager; the seal may include an internal cavity extending substantially the length thereof; the seal may include a hooked portion for clamping the edge of the panel portion; and the seal may be shaped as a wiper blade.

Broadly defined, the present invention according to a fourth aspect includes a rail seal, for attachment to a vertical mounting rail in an electronic equipment enclosure, as substantially shown and described.

Broadly defined, the present invention according to a fifth aspect includes a method of installing a rail seal in an electronic equipment enclosure. The method includes the steps of providing a frame structure and one or more panels attached thereto to define an enclosure; clamping a seal along an edge of a panel portion to form a rail seal; attaching the rail seal to a vertical mounting rail fastened to the frame structure; and aligning the seal to rest along at least one of the one or more panels, thereby forming a vertical air dam between the one or more panels and the vertical mounting rail.

In features of this aspect, the rail seal may be attached to the vertical mounting rail with self-tapping screws; the rail seal may include one or more grommet ports extending therethrough; the method may further include the step of routing one or more cables through the one or more grommet ports; the panel portion may include a notched area for accommodating a finger cable manager; the seal may include an internal cavity extending substantially the length thereof; the seal may include a hooked portion for clamping the edge of the panel portion; and the seal may be shaped as a wiper blade.

Broadly defined, the present invention according to a sixth aspect includes a method of installing a rail seal in an electronic equipment enclosure as substantially shown and described.

Broadly defined, the present invention according to a seventh aspect includes a rail seal kit for providing a vertical air dam in an electronic equipment enclosure, the kit including a panel portion and a seal attachable along an edge thereof.

In features of this aspect, the panel portion may include one or more grommet ports for routing of cables therethrough; the seal may include an internal cavity extending substantially the length thereof; the seal may include a hooked portion for clamping the edge of the panel portion; and the seal may be shaped as a wiper blade.

Broadly defined, the present invention according to an eighth aspect includes a rail seal kit substantially as shown and described.

Broadly defined, the present invention according to a ninth aspect includes an electronic equipment enclosure. The electronic equipment enclosure includes a frame structure, one or more panels attached to the frame structure, at least one vertical mounting rail fastened to the frame structure, and a rail seal attached to the at least one vertical mounting rail. The rail seal includes a generally flat panel portion and a seal along an edge thereof. The seal is adapted to engage at least one of the one or more panels to provide an air dam between the one or more panels and the at least one vertical mounting rail.

In features of this aspect, the rail seal may further include one or more grommet ports in the panel portion for routing of cables therethrough; the rail seal may be attached to the at least one vertical mounting rail with one or more fasteners; and the fasteners may be self-tapping screws.

In further features of this aspect, the panel portion may include a notched area for accommodating a cable manager bracket mounted along a side of the at least one vertical mounting rail; and the cable manager bracket, together with a finger cable manager mounted along an opposite side of the at least one vertical mounting rail, may define a cable manager.

In further features of this aspect, the seal may include an internal cavity extending substantially the length thereof; the seal may include a hooked portion for clamping the edge of the panel portion; the seal may be shaped as a wiper blade; the seal may include a bumper portion for engagement with the one or more panels; and the seal may be composed of a rubber material.

In still further features of this aspect, the rail seal may be fastened vertically along an edge of the at least one vertical mounting rail, with the seal engaging a side panel, thereby providing a vertical air dam between the side panel and the at least one vertical mounting rail; the rail seal may be fastened horizontally between a pair of vertical mounting rails at upper horizontal ends thereof, with the seal engaging a top panel, thereby providing a horizontal air dam between the top panel and the pair of vertical mounting rails; and the rail seal may be fastened horizontally between a pair of vertical mounting rails at lower horizontal ends thereof, with the seal engaging a bottom panel, thereby providing a horizontal air dam between the bottom panel and the pair of vertical mounting rails.

Broadly defined, the present invention according to a tenth aspect includes a rail seal for attachment to a vertical mounting rail in an electronic equipment enclosure. The rail seal includes a generally flat panel portion, a seal along an edge thereof, and one or more grommet ports in the panel portion for routing of cables therethrough. The seal is adapted to engage a panel of an electronic equipment enclosure to provide an air dam therein.

In features of this aspect, the rail seal may be attachable with one or more fasteners; the fasteners may be self-tapping screws; the panel portion may include a notched area for accommodating a cable manager bracket; the seal may include an internal cavity extending substantially the length thereof; the seal may include a hooked portion for clamping the edge of the panel portion; the seal may be shaped as a wiper blade; the seal may include a bumper portion; and the seal may be composed of a rubber material.

Broadly defined, the present invention according to an eleventh aspect includes a method of installing a rail seal in an electronic equipment enclosure. The method includes providing a frame structure and one or more panels attached thereto to define an enclosure, clamping a seal along an edge of a panel portion to form a rail seal, attaching the rail seal to at least one vertical mounting rail fastened to the frame structure, and aligning the seal to rest along at least one of the one or more panels, thereby forming an air dam between the one or more panels and the at least one vertical mounting rail.

In features of this aspect, attaching the rail seal may include attaching the rail seal to the at least one vertical mounting rail with fasteners; and the fasteners may be self-tapping screws.

In further features of this aspect, the rail seal may include one or more grommet ports extending therethrough; and the method may further include routing one or more cables through the one or more grommet ports.

In further features of this aspect, the seal may include an internal cavity extending substantially the length thereof; the seal may include a hooked portion for clamping the edge of the panel portion; the seal may be shaped as a wiper blade; the seal may include a bumper portion; and the seal may be composed of a rubber material.

In another feature of this aspect, attaching the rail seal may include fastening the rail seal vertically along an edge of the at least one vertical mounting rail, and aligning the seal may include aligning the seal to rest along a side panel, thereby forming a vertical air dam between the side panel and the at least one vertical mounting rail.

In another feature of this aspect, attaching the rail seal may include fastening the rail seal horizontally between a pair of vertical mounting rails at upper horizontal ends thereof, and aligning the seal may include aligning the seal to rest along a top panel, thereby forming a horizontal air dam between the top panel and the pair of vertical mounting rails.

In still another feature of this aspect, attaching the rail seal may include fastening the rail seal horizontally between a pair of vertical mounting rails at lower horizontal ends thereof, and aligning the seal may include aligning the seal to rest along a bottom panel, thereby forming a horizontal air dam between the bottom panel and the pair of vertical mounting rails.

Broadly defined, the present invention according to a twelfth aspect includes a rail seal kit for providing an air dam in an electronic equipment enclosure. The kit includes a panel portion and a seal attachable along an edge thereof.

In features of this aspect, the panel portion may include one or more grommet ports for routing of cables therethrough; the seal may include an internal cavity extending substantially the length thereof; the seal may include a hooked portion for clamping the edge of the panel portion; the seal may be shaped as a wiper blade; the seal may include a bumper portion; and the seal may be composed of a rubber material.

In further features of this aspect, the panel portion may be adapted to be fastened vertically in an electronic equipment enclosure along an edge of a vertical mounting rail mounted therein; the panel portion may be adapted to be fastened horizontally in an electronic equipment enclosure at respective upper horizontal edges of a pair of vertical mounting rails mounted therein; and the panel portion may be adapted to be fastened horizontally in an electronic equipment enclosure at respective lower horizontal edges of a pair of vertical mounting rails mounted therein.

Further areas of applicability of the present invention will become apparent from the detailed description provided hereinafter. It should be understood that the detailed description and specific examples indicate a preferred embodiment of the invention, and are intended for purposes of illustration only.

### BRIEF DESCRIPTION OF THE DRAWINGS

Various embodiments of the present invention, which are given by way of example only, will become apparent from the following detailed description with reference to the drawings, wherein:
FIG. 1A is an isometric view of an electronic equipment enclosure, shown with several panels removed to reveal a pair of vertical mounting rails installed therein, each with a pair of rail seals in accordance with one or more preferred embodiments of the present invention;
FIG. 1B is a front cross-sectional view of the electronic equipment enclosure of FIG. 1A, taken along line 1B—1B;
FIG. 2A is an orthogonal partially exploded view of a rail seal panel of one of the rail seals of FIG. 1A;
FIG. 2B is an isometric view of one of the vertical mounting rails of FIG. 1A;
FIG. 3 is an orthogonal partially exploded view of a plurality of rail seals in accordance with FIG. 1A;
FIG. 4A is an end cross-sectional view of a seal of one of the rail seals of FIG. 3, taken along line 4A-4A;
FIG. 4B is an end cross-sectional view of another one of the rail seals of FIG. 3, shown adjacent a side panel of the electronic equipment enclosure, taken along line 4B—4B;
FIG. 5 is an enlarged fragmentary isometric view of a portion of a rail seal similar to one of the rail seals of FIG. 1A but shown installed with a vertical cable manager on a vertical mounting rail;
FIG. 6 is an end cross-sectional view of an alternate embodiment of a seal of a rail seal, shown adjacent a side panel of an electronic equipment enclosure;
FIG. 7 is an end cross-sectional view of another alternate embodiment of a seal of a rail seal, shown adjacent a side panel of an electronic equipment enclosure;
FIG. 8 is an isometric view of the electronic equipment enclosure of FIG. 1A, shown with upper and lower rail seals attached horizontally at respective upper and lower ends of the pair of vertical mounting rails;
FIG. 9 is a front cross-sectional view of the electronic equipment enclosure of FIG. 8, taken along line 9-9;
FIG. 10 is an isometric view of the upper rail seal of FIG. 8; and
FIG. 11 is an isometric view of the lower rail seal of FIG. 8.

### DETAILED DESCRIPTION

As a preliminary matter, it will readily be understood by one having ordinary skill in the relevant art ("Ordinary Artisan") that the present invention has broad utility and application. Furthermore, any embodiment discussed and identified as being "preferred" is considered to be part of a best mode contemplated for carrying out the present invention. Other embodiments also may be discussed for additional illustrative purposes in providing a full and enabling disclosure of the present invention. Moreover, many embodiments, such as adaptations, variations, modifications, and equivalent arrangements, will be implicitly disclosed by the embodiments described herein and fall within the scope of the present invention.

Accordingly, while one or more embodiments of the present invention is/are described herein in detail, it is to be understood that this disclosure is illustrative and exemplary of the present invention. It is not intended that the scope of patent protection afforded the present invention be defined by reading into any claim a limitation found herein that does not explicitly appear in the claim itself.

Thus, for example, any sequence(s) and/or temporal order of steps of various processes or methods that are described herein are illustrative and not restrictive. Accordingly, it should be understood that, although steps of various processes or methods may be shown and described as being in a sequence or temporal order, the steps of any such processes or methods are not limited to being carried out in any particular sequence or order, absent an indication otherwise. Indeed, the steps in such processes or methods generally may be carried out in various different sequences and orders while still falling within the scope of the present invention. Accordingly, it is intended that the scope of patent protection afforded the present invention is to be defined by the appended claims rather than the description set forth herein.

Additionally, it is important to note that each term used herein refers to that which the Ordinary Artisan would understand such term to mean based on the contextual use of such term herein. To the extent that the meaning of a term used herein-as understood by the Ordinary Artisan based on the contextual use of such term-differs in any way from any particular dictionary definition of such term, it is intended that the meaning of the term as understood by the Ordinary Artisan should prevail.

Furthermore, it is important to note that, as used herein, "a" and "an" each generally denotes "at least one," but does not exclude a plurality unless the contextual use dictates otherwise. Thus, reference to "a picnic basket having an apple" describes "a picnic basket having at least one apple" as well as "a picnic basket having apples." In contrast, reference to "a picnic basket having a single apple" describes "a picnic basket having only one apple."

When used herein to join a list of items, "or" denotes "at least one of the items," but does not exclude a plurality of items of the list. Thus, reference to "a picnic basket having cheese or crackers" describes "a picnic basket having cheese without crackers," "a picnic basket having crackers without cheese," and "a picnic basket having both cheese and crackers." Finally, when used herein to join a list of items, "and" denotes "all of the items of the list." Thus, reference to "a picnic basket having cheese and crackers" describes "a picnic basket having cheese, wherein the picnic basket further has crackers," as well as describes "a picnic basket having crackers, wherein the picnic basket further has cheese."

Referring now to the drawings, in which like numerals represent like components throughout the several views, the preferred embodiments of the present invention are next described. The following description of one or more preferred embodiment(s) is merely exemplary in nature and is in no way intended to limit the invention, its application, or uses.

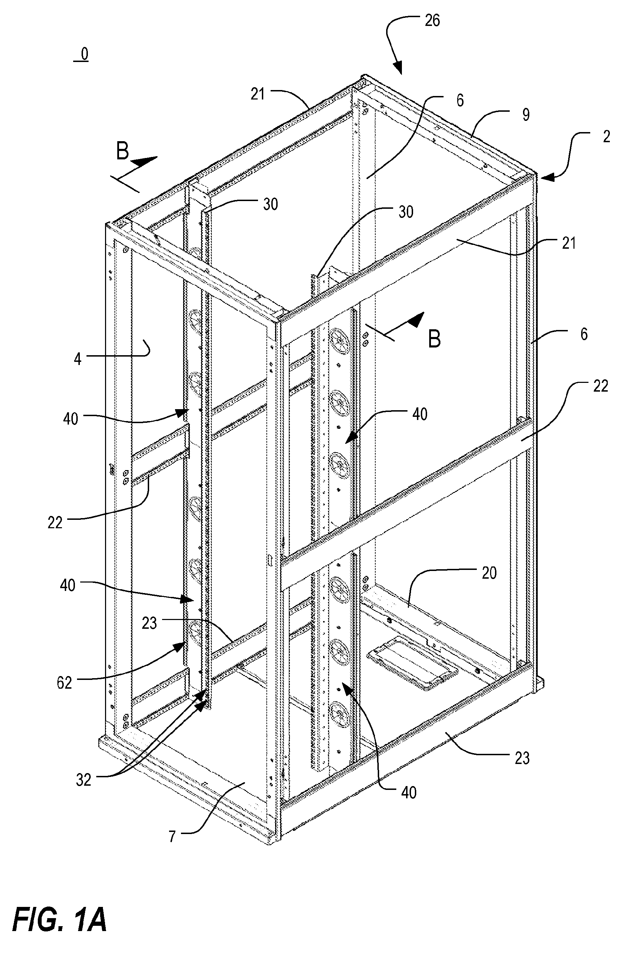

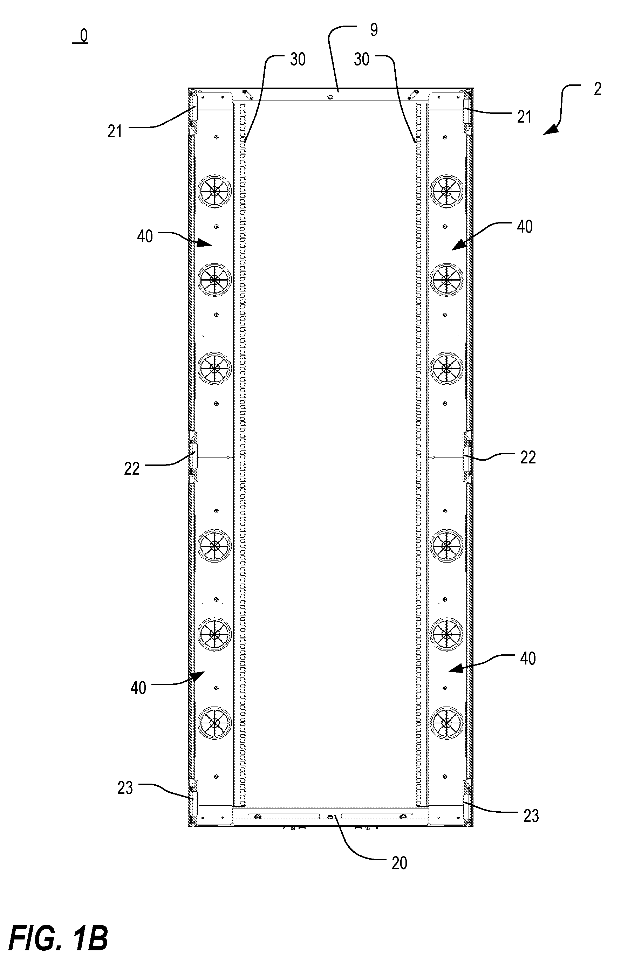

FIG. 1A is an isometric cross-sectional view of an electronic equipment enclosure **10,** shown with several panels removed to reveal a pair of vertical mounting rails **30** installed therein, each with a pair of rail seals **40** in accordance with one or more preferred embodiments of the present invention, and FIG. 1B is a front cross-sectional view of the electronic equipment enclosure **10** of FIG. 1A, taken along line 1B—1B. The electronic equipment enclosure **10** includes a frame structure **12** formed of four vertical support posts **16,** upper and lower front cross members (not illustrated), upper and lower rear cross members **19,20** and three pairs of side cross members **21,22,23.** Each vertical support post **16** includes a plurality of cross member attachment apertures at each end. Two of the vertical support posts **16** are connected together at their upper and lower ends by the upper and lower front cross members, respectively, and the other two support posts **16** are connected together at their upper and lower ends by the upper and lower rear cross members **19,20,** respectively. The front cross members and their respective support posts thus define a front frame (not illustrated), and the rear cross members **19,20** and their respective support posts **16** define a rear frame 26. The front and rear frames may be connected together at their respective corners by the upper, middle and lower side cross members **21,22,23.**

Although the particular enclosure **10** and frame structure **12** described and illustrated herein may include various novel aspects, it will be apparent to the Ordinary Artisan that various aspects of the present invention are likewise applicable to enclosures and structures of generally conventional design and construction. Furthermore, various different connection means may be used to join the various members together. One novel connection means is illustrated in FIG. 1A. However, although not illustrated herein, it will be apparent to the Ordinary Artisan that in at least some embodiments, any of a variety of other connection means may be used instead. In this regard, other examples of conventional connection means are described in commonly-assigned U.S. Patent No. 6,185,098, U.S. Patent No. 7,119,282, U.S. Patent No. 7,697,285, U.S. Patent Application Publication No. US 2009/0190307 A1, U.S. Patent Application Publication No. US 2009/0227197 A1, U.S. Patent Application Publication No. US 2009/0283488 A1, and U.S. Patent Application Publication No. US 2010/0172092 A1. Although likewise not illustrated herein, the precision and the stability of each of the corners of at least some types of four post frame structures may be enhanced by utilizing a self-squaring corner attachment bracket such as that disclosed by the commonly-assigned U.S. Patent No. 5,997,117 entitled "RACK FRAME CABINET,".

Still further, it will be evident to the Ordinary Artisan that in at least some embodiments, other structural arrangements may be used to form a frame structure on which panels may be mounted to form an enclosure. For example, in at least one embodiment (not illustrated), a frame structure may be formed from only two support posts.

The enclosure **10** may further include a plurality of panels, attached to the frame structure **12,** which partially or fully enclose the frame structure **12.** In contemplated embodiments, the enclosure **10** may include a right and/or left panels **14** (a left panel being illustrated in FIG. 1A), a front panel (not illustrated), and a rear panel (not illustrated), one or more of which may be configured to operate as a door to the interior of the enclosure **10.** The enclosure **10** may further include a bottom panel **17** as well as a generally flat top panel (not illustrated). The top panel may be sized and shaped to fit an opening defined by the four vertical support posts **16** in connection with the upper front cross member, the upper rear cross member **19,** and the upper side cross members **21.** The enclosure **10** may include a wide variety of different panel configurations, connection means and other features, such as those that are described in commonly-assigned provisional patent application serial nos. 61/381,904, entitled, "ELECTRONIC EQUIPMENT CABINET STRUCTURE," and 61/381,905, entitled, "CABLE PASS-THROUGH PANEL FOR ELECTRONIC EQUIPMENT ENCLOSURE."

As shown in FIG. 1A and 1B, the enclosure **10** further includes one or more vertical mounting rails **30** that extend therein in a generally vertical orientation and are fastened to the frame structure **12.** One contemplated mechanism for fastening the vertical mounting rail **30** to the frame structure **12** is described in commonly-assigned provisional patent application serial no. 61/381,912, entitled, "RAIL MOUNTING CLAMP FOR ELECTRONIC EQUIPMENT ENCLOSURE." Each vertical mounting rail **30** typically has a series of holes **32** formed therein to facilitate easy mounting of a wide variety of equipment to the frame structure **12.**

As further shown in FIG. 1A and 1B, a pair of rail seals **40** is attached to each of the vertical mounting rails **30.** The rail seals **40** attach to a portion of the corresponding vertical mounting rail **30** and thereby provide a vertical air dam, in the interior of the enclosure **10,** between the side panels **14** and the vertical mounting rails **30.** The rail seals **40** may have any of a variety of different shapes and configurations. For instance, the rail seals **40** may be sized to correspond with an enclosure having any desired height and a width larger than 600 millimeters. In contemplated embodiments, the rail seals **40** are sized to correspond with an enclosure having a width of 750 millimeters and/or an enclosure having a width of 800 millimeters. As will be explained in greater detail below, each rail seal **40** includes a rail seal panel **42** and a seal **50.** The seal **50** is preferably made from a compliant, flexible material. In one contemplated embodiment, the seal **50** is composed of a rubber material. In another contemplated embodiment, portions of the seal **50,** such as the portion that engages a panel, are made from brush bristles (not illustrated).

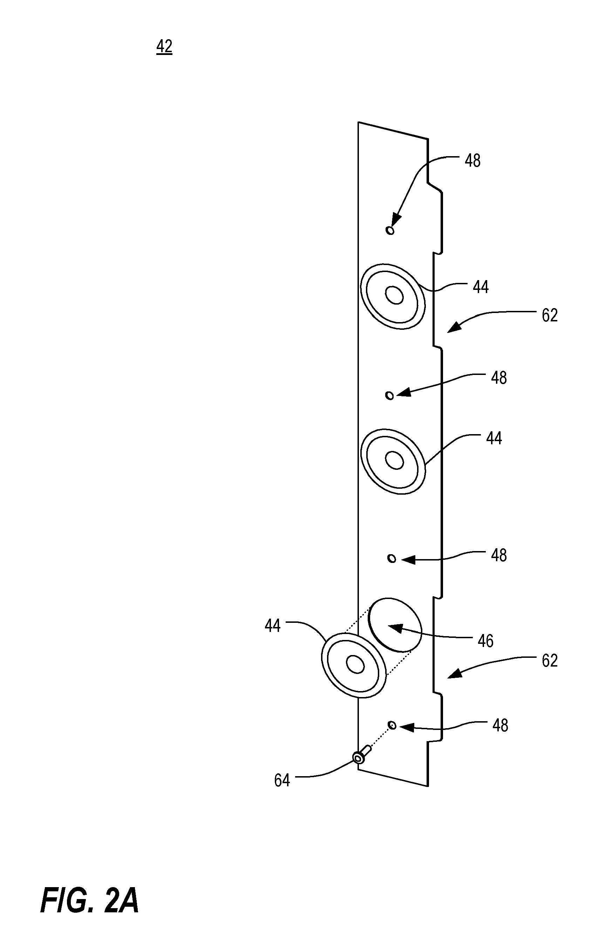

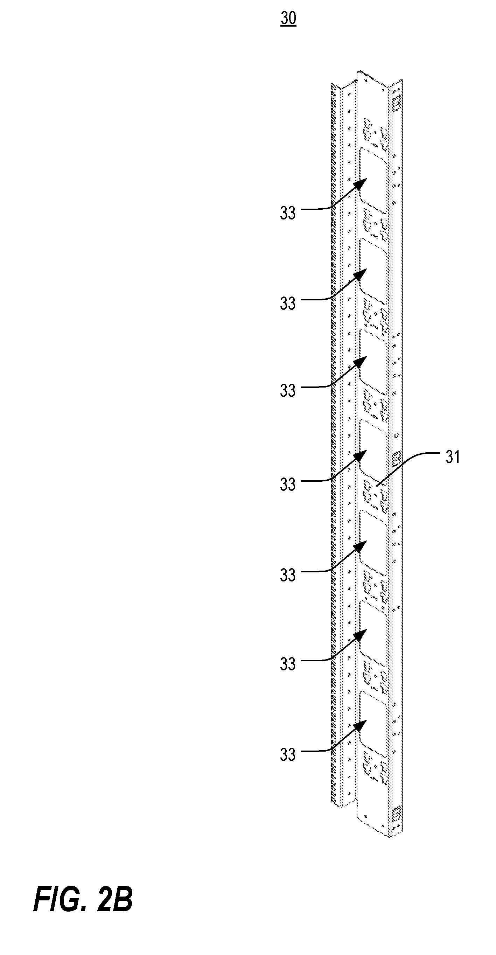

FIG. 2A is an orthogonal partially exploded view of a rail seal panel **42** of one of the rail seals **40** of FIG. 1A. FIG. 2B is an isometric view of one of the vertical mounting rails **30** of FIG. 1A. As shown in FIG. 2A, the rail seal panel **42** is generally flat and includes a plurality of grommets **44,** each corresponding to a grommet port **46** extending through the rail seal panel **42.** The grommets **44** are configured to be removable from the rail seal panel **42** such that cables are permitted to be routed through the resulting grommet port **46.** In this regard, it will be appreciated that the grommets **44** may include an adjustable opening feature such that openings in the grommets may be created or closed off without removing the grommets from the grommet ports **46.** The rail seal panel **42** may accommodate any quantity or shape of grommets **44** and corresponding grommet ports **46.** In one contemplated embodiment, shown in the drawings, the rail seal panel **42** includes three circular grommets **44,** each with a three-inch diameter, and three corresponding circular grommet ports **46.** The rail seal panel **42** is composed of a metal-based material.

The rail seal panel **42** is adapted to be attached via fasteners **64** to a vertical mounting rail **30,** such as that which is shown in FIG. 2B. In particular, the real seal panel **42** includes a plurality of apertures **48** for accommodating fasteners **64.** Fasteners **64,** which may be any of a variety of different fastening mechanisms, extend through the apertures **48** and secure the rail seal panel **42** flatly against a surface **31** of a vertical mounting rail **30.** In one contemplated embodiment, the fasteners **64** are self-tapping screws, such as M5 x 8 millimeter self-tapping screws. As shown in FIG. 2A, the rail seal panel **42** may have four apertures **48** to accommodate four fasteners to mount the rail seal panel **42** to a vertical mounting rail **30.**

It will be appreciated that openings **33** may be provided in the surface **31** of the vertical mounting rail **30** to correspond and align with the grommet ports **46** so as to allow cables and/or air to be routed through the grommet ports **46** when the rail seal panel **42** is mounted on the vertical mounting rail **30.** In particular, as perhaps most apparent from a close inspection of FIG. 1A relative to FIG. 2B, each grommet port **46** may be centered on a large rectangular opening **33** in the main surface **31** of the vertical mounting rail **30.** In the contemplated embodiment, seven large rectangular openings **33** are provided, with all but the middle opening being aligned with a grommet port **46.**

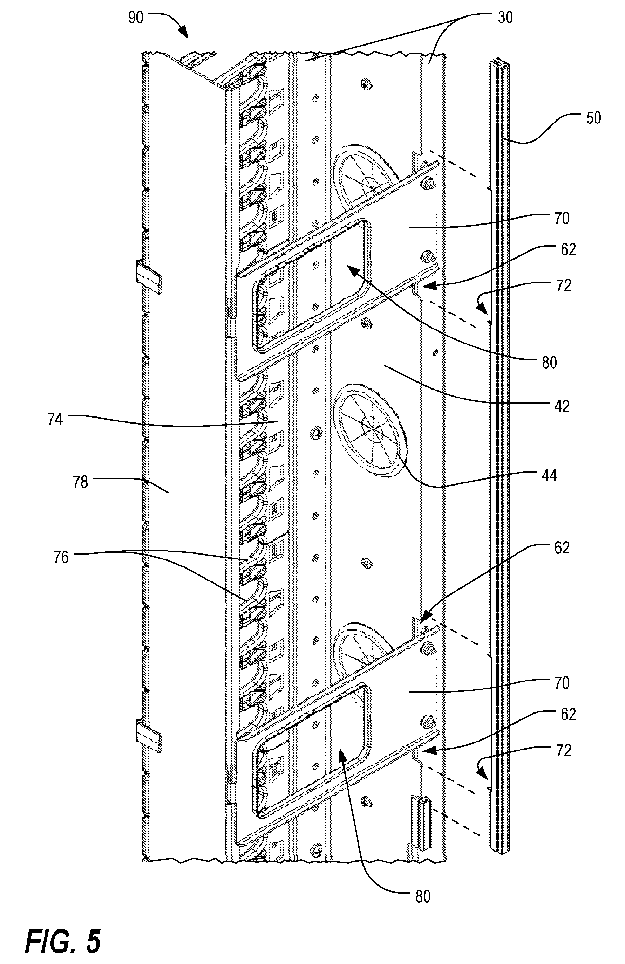

As further shown in FIG. 2A, the rail seal panel **42** may also include one or more notched areas **62** for accommodating additional cable management accessories implemented in the enclosure **10.** In one contemplated embodiment, shown in FIG. 5, the notched areas **62** may be shaped to accommodate a cable manager bracket **70.**

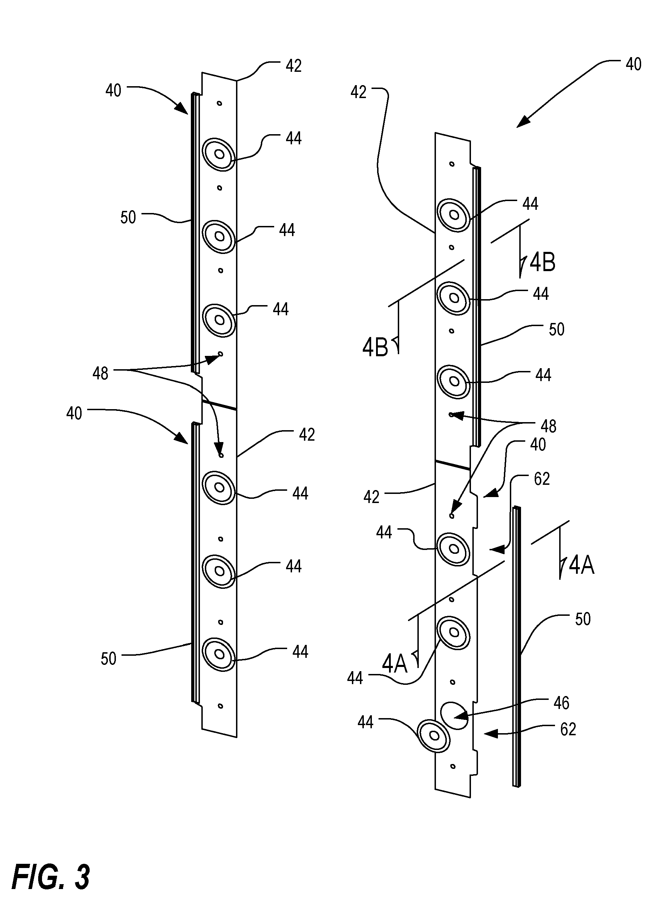

FIG. 3 is an orthogonal partially exploded view of a plurality of rail seals **40** in accordance with FIG. 1A. As shown in FIG. 3, seals **50** may be clamped or otherwise attached along edges of the rail seal panels **42,** thereby providing the rail seals **40** with a flexible sealing surface at edges thereof. In particular, the seals **50** are clamped at outer-facing edges of the rail seal panels **42,** which may interface with and rest against one or more side panels **14** of the enclosure **10.** In this regard, the rail seals **40** provide a vertical air dam at the interior of the enclosure **10** between the side panels **14** and the vertical mounting rails **30.** As further shown in FIG. 3, rail seals **40** may be aligned in an end-to-end relationship with one another.

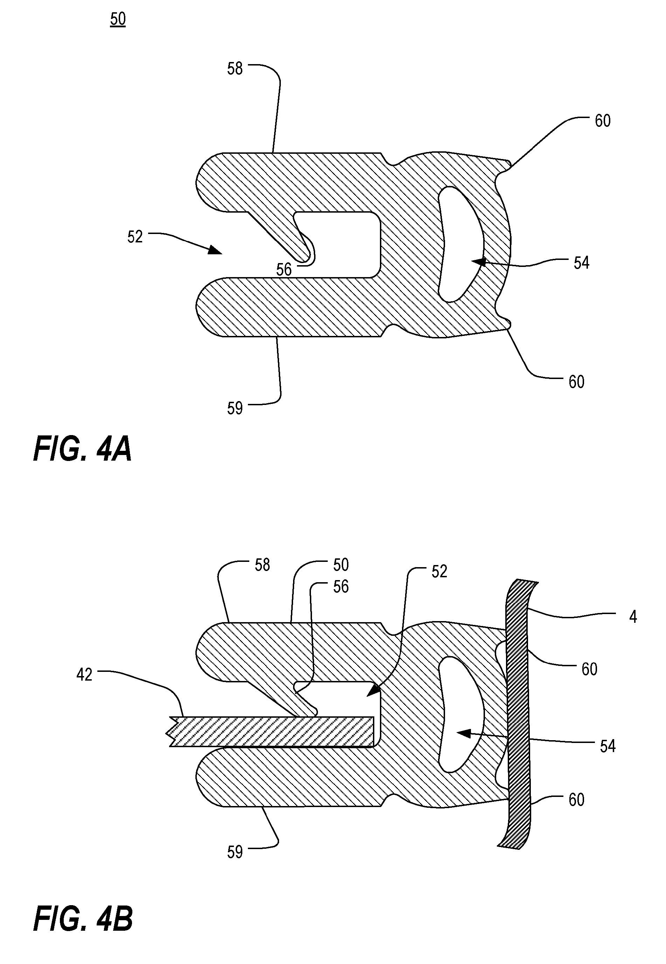

FIG. 4A is an end cross-sectional view of a seal **50** of one of the rail seals **40** of FIG. 3, taken along line 4A-4A; and FIG. 4B is an end cross-sectional view of another one of the rail seals **40** of FIG. 3, shown adjacent a side panel **14** of the electronic equipment enclosure **10,** taken along line 4B—4B. As shown in FIGS. 4A and 4B, the seal **50** of a rail seal **40** includes a pair of extension arms **58,59** extending in the same direction for positioning at either side of an edge of the rail seal panel **42.** Together, the extension arms **58,59** define a channel **52** for receiving the edge of the rail seal panel **42.** The seal **50** may also include a flexible interior cavity **54** at the opposite side from the extension arms **58,59.** Each of the extension arms **58,59** and the interior cavity **54** may extend along the full length of the seal **50.** The seal **50** may also include notched ends **60** adjacent the interior cavity **54,** which may interface with another surface to help establish a seal. One of the extension arms **58** may include a hooked portion **56** to assist in clamping the seal **50** to the edge of the rail seal panel **42,** as can perhaps best be seen in FIG. 4B. When attached, the hooked portion **56** may be deformed slightly in order to clamp the edge of the rail seal panel **42.**

When the rail seal **40** is installed on a vertical mounting rail **30** in an electronic equipment enclosure **10,** the seal **50** is pressed against a side panel **14** of the enclosure **10.** The notched ends **60** interface with the side panel **14,** thereby establishing a seal between the side panel **14** and the vertical mounting rail **30.** The force exerted by the rail seal **40,** when pressed firmly against the side panel **14,** may be evenly distributed throughout the internal cavity **54,** thereby enhancing the effectiveness of the seal. Furthermore, with a flexible sealing surface, the seal **50** can help establish a seal against both flat surfaces and irregular surfaces. For instance, in one contemplated embodiment, the rail seal **40** may be adapted to establish a seal against a side panel or wall that has surface features or other irregularities that create a non-flat surface, as can be seen in FIG. 4B.

FIG. 5 is an enlarged fragmentary isometric view of a portion of a rail seal similar to one of the rail seals **40** of FIG. 1A but shown installed with a vertical cable manager **90** on a vertical mounting rail **30.** In FIG. 5, and with further reference to FIG. 2B, the rail seal panel **42** is shown secured to a flat, front surface **31** of the vertical mounting rail **30.** Cable manager brackets **70** are shown extending through the notched areas **62** between the seal **50** and the rail seal panel **42.** The cable manager brackets **70** may be used in connection with one or more finger cable managers **74** extending from the opposite side of the vertical mounting rail **30** to establish a cable manager **90** (as explained below). In order to further accommodate the cable manager brackets **70,** the seal **50** may itself include one or more notched areas or slits **72** at a portion of the inner edge thereof. Advantageously, the rail seal **40** may be installed in an enclosure **10** with or without cable manager brackets **70.**

As shown in FIG. 5, the cable manager bracket **70** may be used in connection with one or more finger cable managers **74** to establish a cable manager **90** at the vertical mounting rail **30.** The finger cable managers **74** each include a plurality of cable guide projections **76** for supporting and guiding individual cables into and out of the cable manager **90.** Additionally, each cable manager bracket **70** itself may include an opening **80** to permit cable pass-through into and out of the cable manager **90.** A cover **78** may be supported by the distal ends of the finger cable managers **74** and the cable manger brackets **70** to further define and enclose the cable manager **90.** The cover is hingedly attached to one or both of the finger cable managers **74** and the cable manager brackets **70** so as to permit ready access to cables supported in the cable manager 90. As shown in FIG. 5, multiple cable manager brackets **70** may be used to help support the cover **78.**

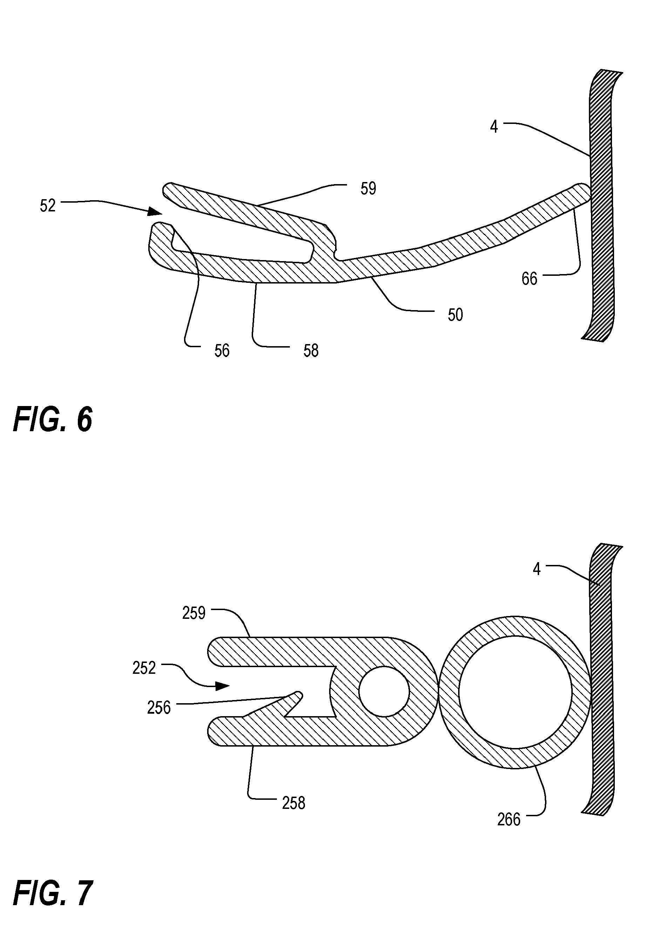

FIG. 6 is an end cross-sectional view of an alternate embodiment of a seal **150** of a rail seal **40,** shown adjacent a side panel **14** of an electronic equipment enclosure **10.** As shown in FIG. 6, the seal **150** has many attributes of the seal 50 addressed hereinabove in connection with FIGS. 4A and 4B. Extension arms **158,159** jointly define a channel **152** for receiving the edge of the rail seal panel **42.** One of the extension arms **158** includes a hooked portion **156** to assist in clamping the seal **150** to the edge of the rail seal panel **42.** The seal **150** may also include a flexible wiper blade end **166,** opposite of the extension arms **158,159,** to interface with another surface to help establish a seal. Additionally, with the flexible wiper blade end **166,** the seal **150** can help establish a seal against both flat surfaces and irregular surfaces. For instance, in one contemplated embodiment, a rail seal **40** utilizing the seal **150** may be adapted to establish a seal against a side panel or wall that has surface features or other irregularities that create a non-flat surface, as can be seen in FIG. 6.

FIG. 7 is an end cross-sectional view of another alternate embodiment of a seal 250 of a rail seal **40,** shown adjacent a side panel **14** of an electronic equipment enclosure **10.** As shown in FIG. 7, the seal **250** has many attributes of the seals **50,150** addressed hereinabove in connection with FIGS. 4A, **4B** and 5. Extension arms **258,259** jointly define a channel **252** for receiving the edge of the rail seal panel **42.** One of the extension arms **258** includes a hooked portion **256** to assist in clamping the seal **250** to the edge of the rail seal panel **42.** The seal **250** may also include a bumper portion **266,** opposite of the extension arms **258,259,** to interface with another surface to help establish a seal. Additionally, the bumper portion **266** can help establish a seal against both flat surfaces and irregular surfaces. For instance, in one contemplated embodiment, a rail seal **40** utilizing the seal **250** may be adapted to establish a seal against a side panel or wall that has surface features or other irregularities that create a non-flat surface, as can be seen in FIG. 7.

The rail seal **40,** as discussed hereinabove, may be provided in the form of, and assembled from, a kit. Kits can be provided with rail seal panels **42** and seals **50,150,250** of varying lengths and widths. In a particular kit, rail seal panels **42** may be provided with notches at ends thereof to assist in orienting and aligning the panels **42** during installation. Additionally, kits can be shipped with the seals **50,150,250** pre-attached at edges of the rail seal panels **42,** thereby affording the rail seal panels **42** with additional strength and rigidity during the shipping process. In one contemplated embodiment, a kit may be provided with four rail seals **40.** Such a kit may specifically include four rail seal panels **42,** four seals **50,150,250,** sixteen fasteners **64,** and twelve grommets **44.**

As can be appreciated by the Ordinary Artisan, the rail seal **40** of the present invention is capable of ready installation in an enclosure **10** from one side of the enclosure **10.** In particular, the rail seal **40** is readily installable from a front of the enclosure **10,** which can enable the rail seal **40** to be retrofitted in an existing enclosure with relative ease. Additionally, with a generally flat shape and a plurality of grommet ports **46,** the rail seal **40** occupies less space within the enclosure **10** and is adaptable for use in connection with a range of different cable management features and options, such as front-to-back/back-to-front cable routing, and/or front-to-back/back-to-front airflow control.

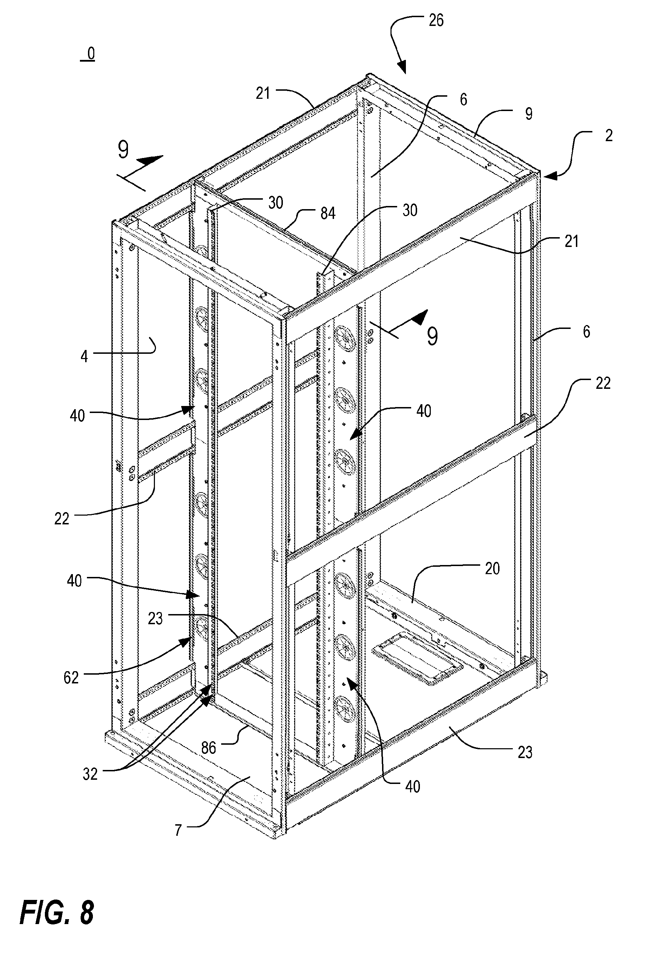

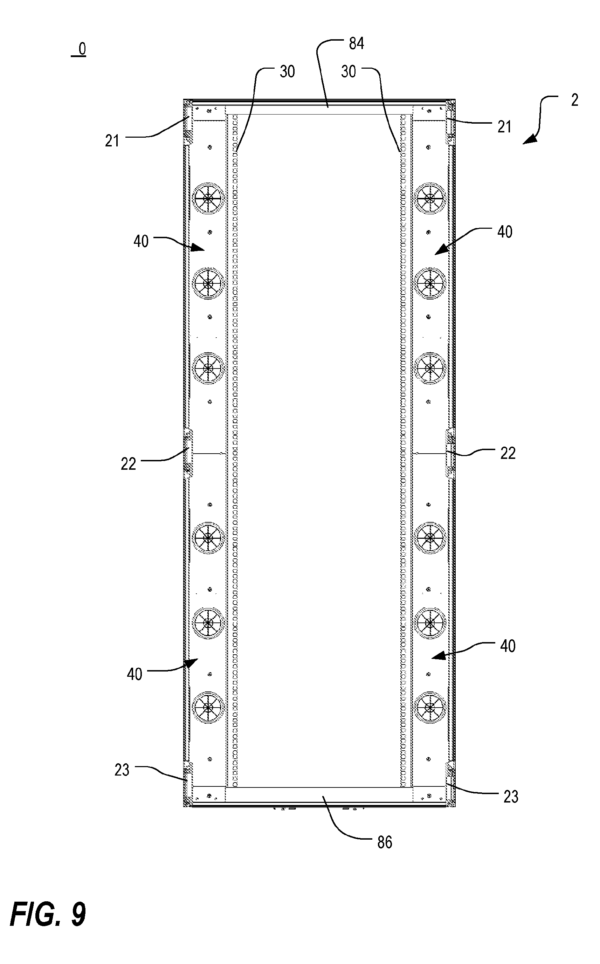

FIG. 8 is an isometric view of the electronic equipment enclosure **10** of FIG. 1A, shown with upper and lower rail seals **84,86** attached horizontally at respective upper and lower ends of the pair of vertical mounting rails **30,** and FIG. 9 is a front cross-sectional view of the electronic equipment enclosure **10** of FIG. 8, taken along line 9-9. As shown in FIGS. 8 and 9, the upper rail seal **84** attaches horizontally atop the pair of vertical mounting rails **30,** thereby providing a horizontal air dam at the interior of the enclosure between the top panel and the pair of vertical mounting rails **30.** In similar fashion, the lower rail seal **86** attaches horizontally at the respective bases of the pair of vertical mounting rails **30** at bottom edges thereof, thereby providing a horizontal air dam at the interior of the enclosure between the bottom panel **17** and the pair of vertical mounting rails **30.** In this manner, the upper and lower rail seals **84,86** facilitate establishment of a seal between the vertical mounting rails **30** and the top panel (not illustrated) and bottom panel **17** of the enclosure **10** and thus help provide a barrier to airflow between interior portions of the enclosure **10.** Advantageously, the upper and lower rail seals **84,86** may have any of a variety of different shapes and configurations as might be desired.

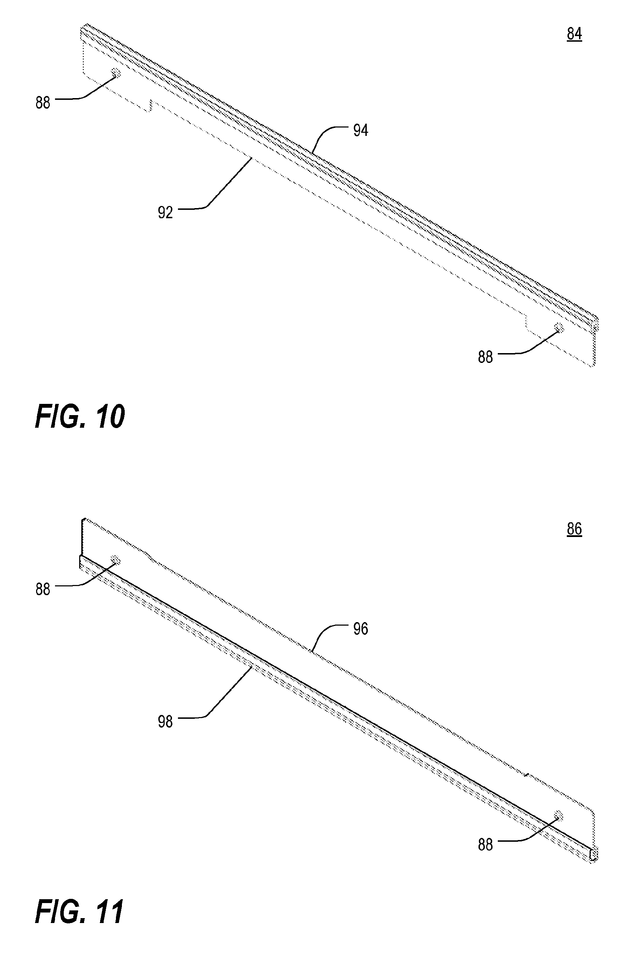

FIG. 10 is an isometric view of the upper rail seal **84** of FIG. 8, and FIG. 11 is an isometric view of the lower rail seal **86** of FIG. 8. As shown in FIG. 10, the upper rail seal **84** includes an upper rail seal panel **92** and a seal **94.** Likewise, as shown in FIG. 11, the lower rail seal **86** includes a lower rail seal panel **96** and a seal **98.** Each seal **94,98** may be clamped or otherwise attached along a horizontal edge of the respective upper and lower rail seal panels **92,96,** thereby providing the rail seals **84,86** with flexible sealing surfaces along edges thereof. In particular, seals **94,98** are clamped at outer-facing edges of the rail seal panels **92,96,** which may interface with and rest against respective top and bottom panels of the enclosure **10.** In this regard, the rail seals **40** provide a horizontal air dam at the interior of the enclosure **10** between the vertical mounting rails **30** and the top and bottom panels of the enclosure **10.** Seals **94,98** may have any of a wide variety of shapes and configurations, including the configurations depicted in FIGS. 4A, 6 and 7. Seals **94,98** are preferably made from a compliant, flexible material. In one contemplated embodiment, seals **94,98** are composed of a rubber material.

The upper rail seal panel **92** is adapted to be attached at its ends via fasteners **88** to upper ends of the pair of vertical mounting rails **b30.** Likewise, the lower rail seal panel **96** is adapted to be attached at its ends via fasteners **88** to lower ends of the pair of vertical mounting rails **30.** Fasteners **88** may be any of a variety of different fastening mechanisms, such as self-tapping screws.

Based on the foregoing information, it will be readily understood by those persons skilled in the art that the present invention is susceptible of broad utility and application. Many embodiments and adaptations of the present invention other than those specifically described herein, as well as many variations, modifications, and equivalent arrangements, will be apparent from or reasonably suggested by the present invention and the foregoing descriptions thereof, without departing from the substance or scope of the present invention.

Accordingly, while one or more preferred embodiments of the present invention has been described herein in detail, it is to be understood that this disclosure is only illustrative and exemplary of the present invention.

## Claims

1. An electronic equipment enclosure comprising:
(a) a frame structure;
(b) one or more panels attached to the frame structure;
(c) at least one vertical mounting rail fastened to the frame structure; and
(d) a rail seal attached to the at least one vertical mounting rail and including a generally flat panel portion and a seal along an edge thereof;
(e) wherein the seal is adapted to engage at least one of the one or more panels to provide an air dam between the one or more panels and the at least one vertical mounting rail.

2. The electronic equipment enclosure of claim 1, wherein the rail seal further includes one or more grommet ports in the panel portion for routing of cables therethrough.

3. The electronic equipment enclosure of claim 1 or claim 2, wherein the rail seal is attached to the at least one vertical mounting rail with one or more fasteners.

4. The electronic equipment enclosure of claim 3, wherein the fasteners are self-tapping screws.

5. The electronic equipment enclosure of any preceding claim, wherein the panel portion includes a notched area for accommodating a cable manager bracket mounted along a side of the at least one vertical mounting rail.

6. The electronic equipment enclosure of claim 5, wherein the cable manager bracket, together with a finger cable manager mounted along an opposite side of the at least one vertical mounting rail, defines a cable manager.

7. The electronic equipment enclosure of any preceding claim, wherein the seal includes a hooked portion for clamping the edge of the panel portion.

8. The electronic equipment enclosure of any preceding claim, wherein the seal is shaped as a wiper blade.

9. The electronic equipment enclosure of any preceding claim, wherein the rail seal is fastened vertically along an edge of the at least one vertical mounting rail, with the seal engaging a side panel, thereby providing a vertical air dam between the side panel and the at least one vertical mounting rail.

10. The electronic equipment enclosure of any preceding claim, wherein the rail seal is fastened horizontally between a pair of vertical mounting rails at upper horizontal ends thereof, with the seal engaging a top panel, thereby providing a horizontal air dam between the top panel and the pair of vertical mounting rails.

11. The electronic equipment enclosure of any preceding claim, wherein the rail seal is fastened horizontally between a pair of vertical mounting rails at lower horizontal ends thereof, with the seal engaging a bottom panel, thereby providing a horizontal air dam between the bottom panel and the pair of vertical mounting rails.

12. A method of installing a rail seal in an electronic equipment enclosure, the method comprising:
(a) providing a frame structure and one or more panels attached thereto to define an enclosure;
(b) clamping a seal along an edge of a panel portion to form a rail seal;
(c) attaching the rail seal to at least one vertical mounting rail fastened to the frame structure; and
(d) aligning the seal to rest along at least one of the one or more panels, thereby forming an air dam between the one or more panels and the at least one vertical mounting rail.

13. The method of claim 12, wherein:
(a) attaching the rail seal includes fastening the rail seal vertically along an edge of the at least one vertical mounting rail; and
(b) aligning the seal includes aligning the seal to rest along a side panel, thereby forming a vertical air dam between the side panel and the at least one vertical mounting rail.

14. The method of claim 12 or claim 13, wherein:
(a) attaching the rail seal includes fastening the rail seal horizontally between a pair of vertical mounting rails at upper horizontal ends thereof; and
(b) aligning the seal includes aligning the seal to rest along a top panel, thereby forming a horizontal air dam between the top panel and the pair of vertical mounting rails.

15. The method of any of claims 12, 13 or 14, wherein:
(a) attaching the rail seal includes fastening the rail seal horizontally between a pair of vertical mounting rails at lower horizontal ends thereof; and
(b) aligning the seal includes aligning the seal to rest along a bottom panel, thereby forming a horizontal air dam between the bottom panel and the pair of vertical mounting rails.
